# EUROPEAN PATENT APPLICATION

(11) **EP 3 944 170 A1**
(43) Date of publication of application: **26.01.2022**
(21) Application number: 21181012.2
(22) Date of filing: 22.06.2021
(51) Int. Cl.: G06Q 10/10, G06Q 10/06, G06Q 50/04

(54) **ASSET MODEL CONFIGURATION AND VALIDATION**

(30) Priority: 23.07.2020 US 202016936576
(71) Applicant: Baker Hughes Oilfield Operations LLC, Houston, TX 77073 (US)
(72) Inventor: LAWRENCE, Stephen, Houston, 77073 (US); BARNES, Kourtney, Houston, 77073 (US); OTTALLAH, Noor, Houston, 77073 (US); PARKER, Scott, Houston, 77073 (US); MAXWELL, Robert, Houston, 77073 (US)
(74) Representative: Illingworth-Law, William Illingworth

(57) **Abstract**

A method includes receiving data characterizing a configuration of an asset configured within an oil and gas production environment. The data can include attribute-value pairs identifying attributes of the configuration of the asset and values of the attributes. The attribute-value pairs can correspond to a hierarchical structure of the asset and sub-components of the asset. The method can include determining a representation of the asset. The representation can be provided in a provided in a language-independent format suitable for use with data interchange application programming interfaces. The method can include determining an asset model of the asset. The asset model can include a digital representation characterize the hierarchical structure of the asset and sub-components of the asset. The asset model can include computer-readable, executable content associated with the attribute-value pairs. The method can include providing asset model. Related systems, techniques, and non-transitory computer readable mediums are also described.

## Description

### BACKGROUND

Asset management systems (AMS) can utilize data associated with physical, virtual, and electro-mechanical assets to provide insight, control, and optimization of the assets. The assets, and collections of assets, can be configured within in an industrial environment and can be managed in AMS software products using data models of the assets. Data models used in some AMS systems can be limited in supporting large numbers of asset variants, system configurations, component hierarchies, and corresponding attribute values for assets in large scale deployments.

Oil and gas production environments can include complex systems of assets, which can be managed using AMS software products. Current AMS software products can require significant time and resources to implement data models that adequately support diverse configurations of large numbers of multi-hierarchical asset systems in a comprehensive asset model. In addition, asset data models in current AMS software products may be prone to error and can require specialized software tools and skilled software programing resources when performing basic tasks using the asset data model, such as instantiation of new assets and/or configuration changes to existing assets within the asset data model.

### SUMMARY

In one aspect, a method for providing an asset model of an asset is provided. In one embodiment the method can include receiving data characterizing a configuration of an asset. The asset can include one of data, a device, and/or a system configured within an oil and gas production environment. The data can include attribute-value pairs identifying attributes of the configuration of the asset and values of the attributes. The attribute-value pairs can correspond to a hierarchical structure of the asset and sub-components of the asset. The method can also include determining a representation of the asset based on the attribute-value pairs included in the received data. The representation can be provided in a language-independent format suitable for use with data interchange application programming interfaces. The method can further include determining an asset model of the asset based on the representation. The asset model can characterize the hierarchical structure of the asset and sub-components of the asset. The asset model can be provided as a digital representation of the asset. The asset model can include computer-readable, executable content associated with the attribute-value pairs. The method can also include providing the asset model. The asset model can be provided.

Non-transitory computer program products (i.e., physically embodied computer program products) are also described that store instructions, which when executed by one or more data processors of one or more computing systems, causes at least one data processor to perform operations herein. Similarly, computer systems are also described that may include one or more data processors and memory coupled to the one or more data processors. The memory may temporarily or permanently store instructions that cause at least one processor to perform one or more of the operations described herein. In addition, methods can be implemented by one or more data processors either within a single computing system or distributed among two or more computing systems. Such computing systems can be connected and can exchange data and/or commands or other instructions or the like via one or more connections, including a connection over a network (e.g. the Internet, a wireless wide area network, a local area network, a wide area network, a wired network, or the like), via a direct connection between one or more of the multiple computing systems, etc.

The details of one or more variations of the subject matter described herein are set forth in the accompanying drawings and the description below. Other features and advantages of the subject matter described herein will be apparent from the description and drawings, and from the claims.

### DESCRIPTION OF DRAWINGS

FIG. 1 is a process flow diagram illustrating an example method of providing an asset model of an asset according to some implementations of the current subject matter.
FIG. 2 is a block diagram of an exemplary computing system configured to perform the method of FIG. 1 according to some implementations of the current subject matter.

Like reference symbols in the various drawings indicate like elements.

### DETAILED DESCRIPTION

AMS software products can utilize data models to represent individual assets and collections of assets. As asset configurations become more diverse and complex, AMS software products can be increasingly reliant on robust designs and interfaces for asset data models. When adding, removing, and managing large numbers of hierarchically complex assets, existing AMS software products can be limited in their ability to efficiently ingest and instantiate asset configuration data in order to determine and generate an error-free asset data model. Manually created asset data models can exclude important data associated with a particular asset, which can cause dependent assets or asset components to be modeled improperly. Since an asset model can be a central data source for a wide variety of AMS software features, it can be important to properly import, classify, and link assets and their corresponding configurations in order to comprehensively manage the assets using the AMS software.

An improved approach to providing asset models is described herein. The approach utilizes a plurality of templates, which include a robust architecture of inter-connected data elements, to determine and generate an asset model suitable for use with assets that include complex hierarchical dependencies. The templates can ensure that all required data is provided and properly formatted, via validation rules, prior to using computational resources to generate the asset model for use in an AMS software product. The templates can further enable rapid import of asset data and automated configuration of the asset model. These benefits can enable asset operators of large asset deployments to quickly configure complex asset models and reduce costs associated with coding, validating, and managing the asset model via AMS software products. Asset operators can further benefit from the improved approach to providing an asset model as described herein, by providing insight into the inter-related data that can be shared among the assets or components of the assets. In this way, asset operators can test and evaluate asset configurations more easily prior to deployment in a physical environment.

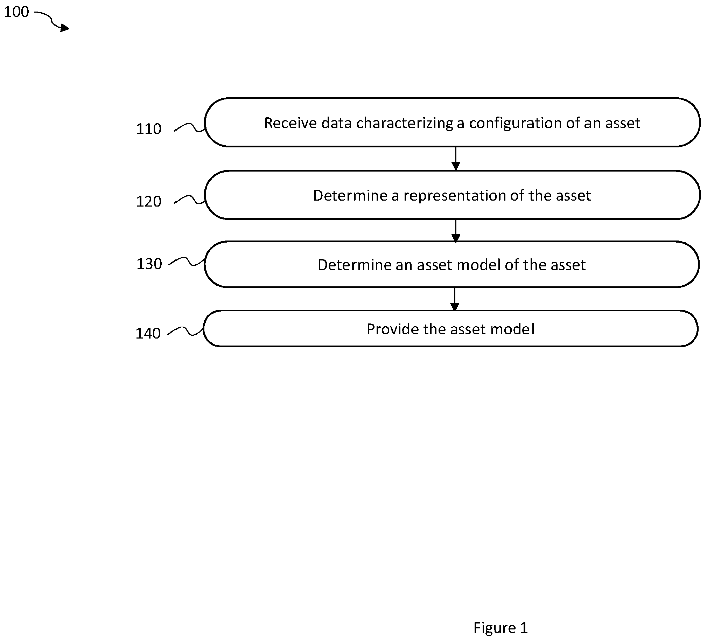

FIG. 1 is a process flow diagram illustrating an example method 100 of some implementations of the current subject matter that can provide an asset model of an asset. At 110, data characterizing an asset configuration of an asset of an oil and gas production environment can be received. The asset can be data, a device, and/or a system that is configured within an oil and gas production environment. For example, the asset can include data associated with a sensor or a service, a device such as a compressor, and/or a system such as a hydrocarbon recovery plant. The asset can also be equipment, such as an accumulator, a reboiler, a scrubber, a separator, a tank, a heat exchange plate, a heat exchange frame, heat exchange shells & tubes, a compressor, a gas turbine, a pump, an electric generator, a control valve, a filter, an axial fan, an electric heater, piping, manifolds, pig launchers, a chemical injection system, a local control panel, or the like.

The data characterizing the configuration of the asset can be received as a set of templates and used to determine an asset model. The set of templates can include attribute-value pairs and data fields associated with the asset. The attribute value pairs and data fields can identify or describe one or more attributes of a configuration of the asset and values of the attributes. The attribute-value pairs can correspond to a hierarchical structure of the asset and sub-components of the asset. The asset model may not be generated if a template or data within a template is missing. In some embodiments, the data characterizing the asset configuration of multiple assets can be received in a compressed file format, such as a .zip file format, a .tar file format, or the like. In some embodiments, the data characterizing the asset configuration of a single asset can be received via a user-interface provided in a display coupled to the data processor.

The set of templates can be implemented as spreadsheets, or a similar data format to provide the attribute-value pairs in fields in a tabular format. The set of templates can be provided in a file, such as a Microsoft Excel file (e.g., a .xls or .xlsx file), which can be generated by the Excel application provided by the Microsoft Corporation. In some embodiments, the templates can be in a delimiter-separated format, such as a comma-separated value format, a tab-separated value format, or a space-separated value format. In some embodiments, the file can be a delimited text file. In some embodiments, a single file can include the set of templates. In some embodiments, each template in the set of templates can be received as a single file. The set of templates can be formatted to accept special characters, such as "!", "@", "#", "$", or the like. In some embodiments, the set of templates can include individual templates including column headers which are not in a consistent order compared to other individual templates in the set of templates. For example, a column header associated with an attribute, such as an asset ID can be provided in a 2^{nd} column in one template and in a 6^{th} column of another template.

The set of templates can include data, such as the attribute-value pairs that are associated with the asset. For example, the attribute-value pairs can be included in data fields in a Hierarchy template, an Equipment template, an Instrument template, and a Connections template. The data in each template can be inter-related, such as subcomponent data relating to data for an asset. The data can also be inter-dependent, such as data that is linked between the templates.

The data characterizing the asset configuration can be validated using rules characterizing valid asset configurations. For validation, all data can be stored in consecutive rows in each template. Each template of the set of templates can be updated and provided to determine an asset model of the asset. The rules characterizing valid asset configurations can include rules configured to validate that each template does not include duplicate data, orphan data, and that all templates with empty fields include a defined "END" field. A defined "END" field can follow all template data provided in consecutive rows. Orphan data can be validated using rules configured to determine that any universal unique identifier (UUID) present in the hierarchy or the Equipment template can also be present in the Connections template. The orphan data rules can further validate that UUIDs present in the Connections template may not be present in the Hierarchy template or in the Equipment template. In some embodiments, the rules characterizing valid asset configurations can be configured to validate that parent and child column names are defined consistently within a template in order to keep asset-level relationships intact. In some embodiments, the rules characterizing valid asset configurations can be configured to validate that a UUID is defined in a single classification instance across each template in the set of templates. In some embodiments, the rules characterizing valid asset configurations can be configured to validate that value settings are consistently applied to tags. Additional descriptions of validation rules pertaining to specific templates will be provided below in the description of each template type.

The Hierarchy template can include data describing a hierarchical structure of the asset within the oil and gas production environment. The Hierarchy template can include data identifying the systems of the asset. The data included in the Hierarchy template can be utilized to populate asset elements within an asset management application. The Hierarchy template can be named "Hierarchy Elements" although no template name is explicitly required. Any blank template in the set of templates is required to include the word "END" in the first row of the blank template. Column data in the Hierarchy template can be contiguous with column headers included for every column containing data. Interspersed column data can cause the Hierarchy template to be invalidated. The Hierarchy template can include the following attribute fields required described in Table 1 below.

**Table 1**

| Attribute Name | Notes |
|---|---|
| Universal Unique Identifier (UUID) | A unique identifier identifying each data, device, component, or system of the asset. Avoid use of "." in UUID data. |
| Short Name | Short name of the data, device, component, or system of the asset. |
| Full Name | Full name of the data, device, component, or system of the asset. |
| Description | Description of the data, device, component, or system of the asset. |
| Type | Type of the data, device, component, or system of the asset. This field identifies the level of the template sheet row in the asset hierarchy. Selected from pre-determined values. |
| Sub-Type | The sub-type of the data, device, component, or system of the asset. |
| Registration Site | The UUID of a platform. If the Type of this row item is "Segment", this field is the UUID value of the parent "Platform" Type row item. |
| Commissioning System | A number or letter identifying a commissioning system of an asset. |
| Tag Number | A number or letter identifying a tag of an asset. |
| System | A number or letter identifying a system of an asset. |
| Page_Type | Selected from pre-determined values. The Page Type field determines the page view the application management application displays when the element is selected. |
| Time Zone | The time zone in which the data, device, component, or system of the asset resides. Selected from pre-determined values. Special character "/" is allowed. |
| Excursion_Cases_Anomalies | "Yes" or "No". Can be used by external applications, which utilize one or more asset templates described herein to create excursions, cases, and determine anomalies based on this field. |
| Reports | "Yes" or "No". Can be used by external applications, which utilize one or more asset templates described herein to create reports based on this field. |
| Dashboard | "Yes" or "No". Can be used by external applications, which utilize one or more asset templates described herein to update a Dashboard or User-Interface based on this field. |

The Hierarchy template data will be validated to ensure no duplicate or orphan data is included. Every value in the Parent attribute column and Child attribute column in the Connections template can appear as a value in the appropriate required column of the Hierarchy template, the Equipment template, and the Instrument template. The Hierarchy template will be validated using one or more rules as described in table 2 below.

**Table 2**

| Attribute Name | Validation Rule |
|---|---|
| Type | Includes one of "Company", "Region", "Platform", or "Segment". |
| Page_Type | Includes one of "Company", "Region", "Platform", "System", "Subsystem", or "None". |
| Time Zone | Includes valid time zone format. Special character "/" is allowed. |
| Any | All sheets with empty fields include an "END" field defined in the "Property" and "Attribute" fields first row. |

The Equipment template can include data describing the types of equipment associated with the asset. The data can include equipment dimensions, and operating parameters, such as pressures or temperatures. The Equipment template can require at least one Equipment sheet and an Equipment Package sheet. The Equipment template can contain multiple Equipment sheets. Each Equipment sheet can contain pieces of equipment which are of the same type. For example, an Equipment sheet for a "Pump", can contain multiple rows, such that each row identifies an individual glycol pump. Each item in the Child attribute column of the Hierarchy to Equipment sheet included in the Connections template can also be included in an Equipment sheet of the Equipment template. Any blank sheet within the Equipment template can include the word "END" in the first row. Data in attribute columns of the Equipment template can be contiguous with attribute column headers included for every attribute column containing values. Interspersed column data can cause the Equipment template to be invalidated.

The Equipment template can include an Equipment Package sheet, at least one other sheet that contains children subcomponent values associated with a parent component value, and sheets for each piece of equipment.

The Equipment template can include the following required data attribute described in Table 3 below.

**Table 3**

| Attribute Name | Notes |
|---|---|
| Equipment UUID | A unique identifier identifying the equipment associated with each data, device, component, or system of the asset. Avoid use of"." in UUID data. |
| Short Name | Short name of the equipment associated with each data, device, component, or system of the asset. |
| Description | Description of the equipment associated with each data, device, component, or system of the asset. |
| Asset Type | A text field providing an abbreviation to represent the type of asset. |
| UI Prefix | A text field used by external applications using one or more asset templates described herein. |
| Equipment Package Sheet | Include Parent column and Child column. |

The Equipment template data can be validated to ensure no duplicate or orphan data is included. Every value in the Parent attribute column and in the Child attribute column in the Equipment template can appear as a value in the appropriate required attribute column of the Hierarchy template, the Connections template, and the Instrument template. The Equipment template can be validated using one or more rules as described in table 4 below.

**Table 4**

| Attribute Name | Validation Rule |
|---|---|
| Time Zone | Includes valid time zone format. Special character "/" is allowed. |
| Any | All sheets with empty fields include an "END" field defined in the Property and Attribute column's first row. |

The Instrument template can include tag information associated with an asset. Tags can be unique identifiers for data streamed from a piece of equipment. For example, information from sensors can be tagged. Information can include what is being measured (e.g., pressure, flow, temperature, etc.), units of measure (e.g., %, kW, PSI, or the like), upper (e.g., maximal) range of values, and lower (e.g., minimal) range of values. Tag information can be used with external applications (e.g., a time-series based application) to associate measurement values from equipment to tag identifiers. Attribute data in the columns of the Instrument template can be contiguous with column headers included for every column containing data. Interspersed attribute column data can cause the Instrument template to be invalidated. The Instrument template can include a Transmitter sheet, an Analog Tag sheet, a Digital Integer sheet, a Digital Text Tag sheet, a Limit sheet, and a Deviation Values sheet. The Transmitter sheet, the Analog Tag sheet, the Digital Integer sheet, the Digital Text Tag sheet, the Limit sheet, and the Deviation Values sheet can be included as required data of the Instrument template.

The Transmitter sheet can include attribute data describing instruments that collect data measurements associated with a piece of equipment, such as a temperature or a pressure. The Transmitter sheet can contain technical information about the transmitters used in an asset, system, or facility. The Transmitter sheet can include the following required attribute data described in Table 5 below.

**Table 5**

| Attribute Name | Notes |
|---|---|
| Instrument UUID | A unique identifier identifying the instrument associated with each data, device, component, or system of the asset. Avoid use of"." in UUID data. Every child included in this column can be included as required data on the Equipment to Transmitters sheet of the Connections template. |
| Short Name | Short name of the instrument associated with each data, device, component, or system of the asset. |
| Description | Description of the instrument associated with each data, device, component, or system of the asset. |
| Functional Class Name | Determines an object type and an object function in the asset management application data model. |

The Analog Tag sheet can include unique identifiers for analog data that is streamed from a piece of equipment. The values of the streamed data can be provided as floating point numbers and can be used to detect excursions. Excursions can include events that can be created by an external application using information in the one or more asset templates described herein. An excursion can be a point at which the measured value, e.g., a tag, for an instrument is outside of a defined operating range. The Analog Tag sheet can include technical information about the analog tags that are used in an asset, system, or facility.

The Instrument template can also include a Digital Integer Tag sheet. The Digital Integer Tag sheet can include unique identifiers for digital integer data that is streamed from a piece of equipment. The values can be streamed as whole numbers, e.g., integers, and can be used to detect excursions. The Digital Integer Tag sheet can include technical information about the digital integer tags that are used in an asset, system, or facility.

The Instrument template can also include a Digital Text Tag sheet. The Digital Text Tag sheet can include unique identifiers for digital text data this is streamed from a piece of equipment. The values can be streamed as text. The digital text data can be used to detect excursions. The Digital Text Tag sheet can include technical information about the digital text tags that are used in an asset, system, or facility.

The Analog Tag sheet, the Digital Integer Tag sheet, and the Digital Text Tag sheet can include the following required attribute data described in Table 6 below.

**Table 6**

| Attribute Name | Notes |
|---|---|
| Tag UUID | A unique identifier identifying the tag associated with each data, device, component, or system of the asset. Avoid use of "." in UUID data. Every child included in the Transmitters to Tags sheet of the Connections template can be included on one of the Analog Tag sheet, the Digital Integer Tag sheet, or the Digital Text Tag sheet. |
| Short Name | Short name of the tag associated with each data, device, component, or system of the asset. |
| Description | Description of the tag associated with each data, device, component, or system of the asset. |
| Output Range Upper | An Upper (max) range for instrument (tag) measured values. |
| Output Range Lower | A Lower (min) range for instrument (tag) measured values. |
| Unit of Measure | Any unit of measure. Examples include percentages, kW, or PSI. |
| Tag Type | Identifies whether tag is a time-series streaming measurement value or a setpoint (threshold) value. |
| Tag Measure | Identifies what is being (pressure, flow, temperature). |

The Instrument template can further include a Limits sheet. The Limits sheet can define excursion scenarios. The Limits sheet can define the limits set for excursion detection. The limits can be static, in which they can be defined via a Setting column, or the limits can be dynamic, in which they can be defined via a Set Point Tag column. The Limits sheet can also include one or more deviation values associated with the excursion scenarios. The deviation values can define threshold (limit) values that a measurement value can go above (high) or below (low) in order for an event, such as an excursion to occur. The Limits sheet can include the following required attribute data described in Table 7 below.

**Table 7**

| Attribute Name | Notes |
|---|---|
| Monitor Name | A monitor name can be used once for each excursion type/sub-type combination. |
| Tag UUID | A unique identifier identifying the tag associated with each data, device, component, or system of the asset. Avoid use of "." in UUID data. The Tag UUID can appear as required data on the Transmitters to Tags sheet of the Connections template. |
| Equipment UUID | A unique identifier identifying the equipment associated with each data, device, component, or system of the asset. Avoid use of"." in UUID data. The Equipment UUID can appear as required data on the Hierarchy to Equipment sheet of the Connections template. |
| Excursion Type | A pre-determined list of excursion types including not limited to "MOL" (Monitored Operating Limit), "SOL" (Safe Operating Limit), "SDL" (Safe Design Limit), and "PSV" (Pressure Safety Valve). |
| Excursion Sub-Type | A text field to further classify an excursion. |
| Severity | A severity of excursion event if it occurs. Can be used by external applications. Populated only with values ranging from "1"-"3". |
| High or Low | Identifies whether excursion would occur if the measured value went above (H - high) the limit or below (L - low). Populated only with values "H" or "L". |
| Set Point Tag and/or Set Point Setting | Each monitored limit must have only one of either the Set Point Tag or the Set Point Setting column fields populated. Set Point Setting fields can be required to include a decimal value or a null value. |
| Override Test Tag and/or Override | These tags stream values that can be used to determined what type of excursion is created for a given monitor. |
| Trip Tag | These tags be used to determine ACT excursions. Can be used by external applications. |
| Reset dB | Time in seconds that a streamed value must remain below and excursion threshold for the excursion to end. |
| Reset Deadband% | Percentage by which a streamed value must remain below an excursion threshold for the excursion to end. |
| Safety Integrity Level (SIL) Rating | Populated only with values "NON SIL", "SIL 0", "SIL 1," or "SIL 2". |
| API14C | Populated only with values "Yes" or "No". API-RP-14C, developed by the American Petroleum Institute exemplifies the effect of that influence on a procedure by which safety systems and controls on procedure by which safety systems and controls on offshore platforms are designed and installed. |
| IPL | Populated only with values "Yes" or "No". |
| Non_Report_State | Populated only with values "True", "False", or "Undetermined". Identifies wherein an excursion (event) is non-reportable. |

The Limits sheet can optionally include an Active attribute column. This is column may not be required and can be used to indicate whether an asset is or is not decommissioned. If the asset is decommissioned, the no excursions will be created for that asset. The value for this column can be provided as "Yes" or "No".

The Instrument template can also include a Deviation Values sheet. The Deviation Values sheet can include an additional way to define operation values and limits for an instrument (tag). The Deviation Values sheet can include the following required attribute data described in Table 8 below.

**Table 8**

| Attribute Name | Notes |
|---|---|
| PI Tag | A unique identifier for an instrument tag. |
| Visibility High Set Point | High limit or threshold. |
| Reference Set Point | Normal limit or threshold |
| Visibility Low Set Point | Low limit or threshold |
| Active | Whether the instrument (tag) is or is not decommissioned |

The Instrument template data will be validated to ensure no duplicate or orphan data is included. Every value in the Parent attribute column and in the Child attribute column in the Connections template can appear as a value in the appropriate required column of the Hierarchy template, the Connections template, and the Equipment template. Any blank sheet within the Equipment template can include the word "END" in the first row. The Instrument template can be validated to confirm that a single, unique monitor name can be used once for each excursion type/sub-type combination. The excursion type/sub-type combinations can include a) Monitored Operating Limit (MOL) High/MOL Low, b)Safe Operating Limit (SOL) High/SOL Low, c) Safe Design Limit (SDL) High/SDL Low, and d) SDL Pressure Safety Valve (PSV) High/SDL PSV Low. For example, if a given monitor name has a MOL High limit defined, it cannot be listed again for a different MOL High limit. However, it can be used to define an SDL Low limit, an SOL High limit, or an SOL Low limit.

Thresholds for the monitors can also be validated by this rule. For example, in one embodiment for a high excursion type, the SDL value must be greater than the SOL value, which also must be greater than the MOL value, such that the values for MOL<SOL<SDL. In another embodiment, for a low excursion type, if a tag has a MOL threshold and an SOL threshold, the MOL setting value can be greater than the SOL setting value, such that MOL>SOL>SDL. One or more of the Instrument template sheets can be validated using one or more rules as described in table 9 below.

**Table 9**

| Sheet Name | Attribute Name | Validation Rule |
|---|---|---|
| Analog Tag | Unit of Measure | Includes an Application Performance Management accepted value? |
| Digital Integer Tag | Unit of Measure | Includes an Application Performance Management accepted value? |
| Digital Text Tag | Unit of Measure | Includes an Application Performance Management accepted value? |
| Analog Tag, Digital Integer Tag, and Digital Text Tag | Tag UUID | Includes valid tag in each sheet? Includes valid parent in Connections template? Defined as analog value in Analog Tag sheet? |
| Limits | Tag UUID | Includes defined instrument range, such as full scale values? Static set points can be defined for monitor tags if within respective PV tag instrument range. |
| Limits | One of Set Point, Tag, or Setting | Include at least one populated cell in any of the Set Point, Tag, or Setting columns? |
| Limits | Monitor Name | Includes unique name for each equipment type and sub-type combination? |
| Limits | Excursion Type | Excursion types with same tag UUID and equipment include same Monitor name? |
| Limits | Excursion Type | Excursion types with same tag UUID but different equipment include different Monitor Name? Include only MOL, SOL, or SDL values? |
| Limits | Severity | Only includes values ranging from "1"-"3"? |
| Limits | High or Low | Only includes values "H" or "L"? |

The Connections template can provide a mapping of the inter-dependent and inter-related relationships between data, devices, components, systems, tags, and transmitters associated with an asset. Every value in the Parent attribute column and in the Child attribute column in the Connections template can appear as a value in the appropriate required column of the Hierarchy template, the Equipment template, and the Instrument template. In this way, the Connections template can include data linking the data included in the Hierarchy template, the Equipment template, and the Instrument template.

The Connections template can include the following required attribute data, which can be provided as individual sheets within the Connections template: a Functional Hierarchy sheet, a Hierarchy to Equipment sheet, an Equipment to Transmitter sheet, and a Tag Associations sheet. The Connections template can also include the following attribute data, which is not required and can similarly be provided as individual sheets within the Connections template: a Tags to Tags sheet, an Associated Trends sheet, and a Tag Associations sheet. If a non-required data sheet is included in the Connections template and is blank, the sheet must contain the word "END" in the first row. Attribute values in the columns of the Connections template can be contiguous with attribute values in the column headers included for every column containing data. Interspersed column data can cause the Connections template to be invalidated.

The Connections template can include the following required attribute data described in Table 10 below.

**Table 10**

| Sheet Name | Attribute Name | Notes |
|---|---|---|
| Functional Hierarchy | Parent, Child, Property or Attribute, Hide, UUID, Short Name, Description, Type, Page Type, Time Zone | |
| Hierarchy to Equipment | Parent, Child, and Hide | The parent column can originate from the Hierarchy template. The child column must originate from the Equipment template. |
| Equipment to Transmitters | Parent, Child, and Instrument UUID | All instrument UUIDs in the Transmitter sheet of the Instrument template can be a child in this sheet of the Connections template. |
| Transmitters to Tags | Parent, and Child | The Parent column can originate from the Transmitters sheet of the Instrument Template. The Child column can originate from the Analog Tag, the Digital Integer Tag, or the Digital Text Tag sheet of the Instrument template. |
| Tags to Tags | Parent, and Child | The Parent and the Child column can originate from the Analog Tag, the Digital Integer Tag, or the Digital Text Tag sheet of the Instrument template. |
| Associated Trends Sheet | Parent, and Child | Defined tags that appear on system trends in the asset management application. Each hierarchy can have its own trend data and tags are required separately for each hierarchy level. The Parent column can originate from the Hierarchy template, and the Child column can originate from the Analog Tag, the Digital Integer Tag, or the Digital Text Tag sheet of the Instrument template. |
| Tag Associations | Parent, and Child | The Parent and the Child column can originate from the Analog Tag, the Digital Integer Tag, or the Digital Text Tag sheet of the Instrument template. |

The Connections template data can be validated to ensure no duplicate or orphan data is included. Every attribute value in the Parent attribute column and in the Child attribute column in the Connections template can appear as a value in the appropriate required attribute column of the Hierarchy template, the Equipment template, and the Instrument template. The Connections template can further be validated to ensure it contains all sheets described in Table 10, except the Tags to Tags sheet, which is not required. In some embodiments, a Heat Map Sub-system sheet and a Node Grouping sheet can also be required in the Connections template. The Connections template can be validated to ensure that any empty sheets include the word "END" in the Property and Attribute field's first row.

The set of templates described in relation to operation 110 advantageously provide for greater numbers of asset hierarchy levels without restriction. In addition, the set of templates and the format of required attribute data therein can provide enhanced mapping of interdependent data, components, and/or systems associated with the asset. The format, scope of hierarchical support, and inter-linked data provided by the set of templates can reduce errors in asset model creation and can enable instantiation of new or changes to existing asset configurations on a large scale with more accurate asset implementations within an asset data model. For example, in response to any of the validation rules described above failing to validate one or more templates in the set of templates, error messages can be provided indicating an invalid asset configuration. Proper correction can be provided in the user-friendly format of the set of templates, and invalid asset configurations can be rapidly fixed.

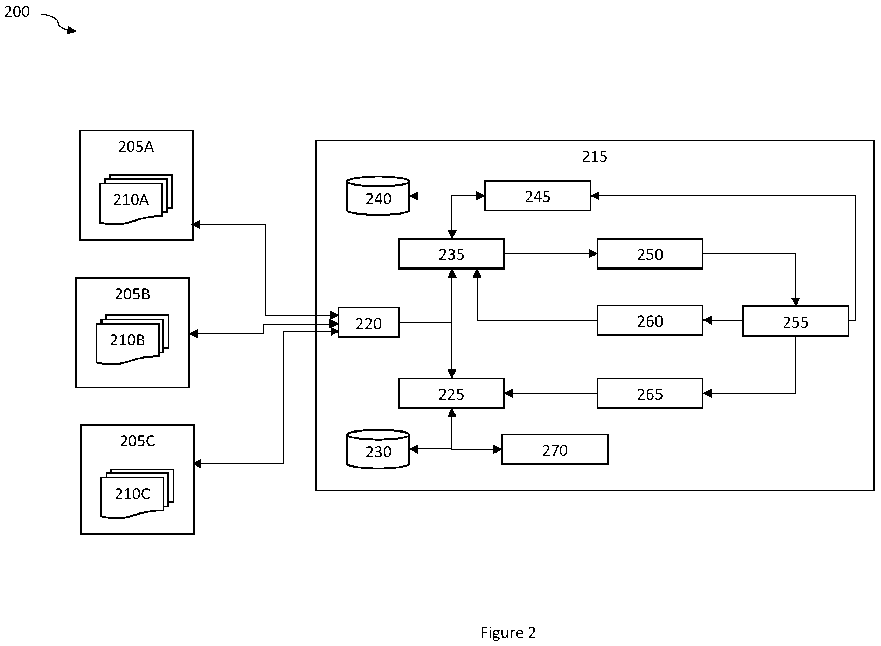

Referring again to FIG. 2, at 120, a representation of the asset can be determined based on the attribute-value pairs included in the data received at operation 110. The representation can be provided in a language-independent format suitable for use with data interchange application programming interfaces. In this way, the representation can include attribute-value pairs as serializable values which can be translated into data structures or object states for later reconstruction within different platforms or operating system environments. In some embodiments, the representation can include a JavaScript object notation (JSON) file.

The representation can be created by parsing the set of templates to create the JSON file. For example, the JSON file can be created by parsing the set of templates using a library or parsing service, such as an Apache POI library by the Apache Software Foundation. Once the set of templates has been parsed, the parsing service creates an intermediate.json file, using a standard JAVA JSON Object library, which is a flat file of the excel templates with no modification. The representation can be validated using one or more validation rules.

The validation results can be stored in a database and can be available to the user for review before continuing the asset model creation. The representation can be provided to a transformation message queue and can be queued for transformation by a transformation service. Transformation can include parsing the intermediate.json file retrieved from the transformation message queue to create the asset model based on identifiers configured within the JSON file. The identifiers can originate in the set of templates as the column names from the templates. In the JSON file, these can become the keys for the properties. During transformation, an additional validation can occur in case the representation was generated with errors. For example, the additional validation of the representation can include reviewing errors generated during the parsing, reviewing the asset configuration in a user interface (UI), and/or comparing the representation JSON file to previous versions. The representation, e.g., the JSON file, can be compared to previous versions using a file comparison tool. Any observed differences can be validated against expected changes.

The errors generated in the validation of the JSON file can be provided to the parsing service through a status message queue and can be stored along with the other error messages during parsing of the set of templates. Once the asset model has been created, the model is then sent to the asset message queue in chunks awaiting for an asset service to retrieve the asset model and to store it in a database.

At 130, an asset model of the asset can be determined based on the representation determined at operation 120. The asset model can characterize the hierarchical structure of the asset and the sub-components of the asset. The asset model can include a digital representation of the asset and can include computer-readable, executable content, such as code, which can be associated with the attribute-value pairs of the received data. In some embodiments, the digital representation can include a digital twin of the asset. The digital twin can model the hierarchical structure, operation, data inputs and outputs, and physical components associated with the asset. The asset model or digital twin can be used in an asset management application configured to test, simulate, and/or manage one or more assets.

The asset model can be created by parsing the representation based on the identifiers included in the representation. The JSON file is constructed of key value pairs where the key is the column name and the value is the row value. These are then stored in a database with a similar structure as the excel templates.

At 140, the asset model can be provided. The asset model can be available to a variety of services, systems, and/or applications for use in configuring and managing the assets included in the asset model. In some embodiments, the asset model can be provided to an asset management system (AMS) software product configured to execute the asset model. In some embodiments, the asset model can be provided in a graphical UI that is associated with the AMS. In some embodiments, the asset model can be utilized in the asset management application by providing predictions of asset failures, warnings regarding asset configurations, and recommendations regarding operating parameters when the asset model is executed. In some embodiments, the asset management application can be configured to receive sensor data that is associated with operating parameters of the asset. The sensor data can be provided as inputs to the asset model. When executed, the asset model can generate alerts based on the sensor data exceeding pre-determined threshold values which have been configured in relation to the operating parameters.

FIG. 2 is a block diagram illustrating an example system 200, configured to provide an asset model as described herein. As shown in FIG. 2, the system 200 can include one or more client computing devices 205 and a server computing device 215. In some embodiments, the components shown within the server computing device 215 can be implemented on one or more distributed or virtual computing platforms, and/or as microservices.

The client devices 205 can be computing devices associated with a data 205A from a deployment user, a physical device or component of a machine 205B associated with a business user, and a system of data and/or devices 205C associated with a business administrator. A plurality or set of templates 210 can be received from each of the computing devices 205. In some embodiments, a set of templates 210 can be received from a computing device communicatively coupled to an AMS. The set of templates 210 can include a Hierarchy template, an Equipment template, an Instrument template, and a Connections template as described in relation to operation 110 of FIG. 1. The Hierarchy template can include asset classifications such as "Customer", "Region", and "System". The Equipment template can include asset sub-classifications. By default, all items in the Equipment template can be classified as "Equipment". The Instrument template can include asset classifications, such as "Transmitter" and "Tag". The Connections template can utilize the IDs from the Equipment, Instrument, and Hierarchy templates to map or link relational data across the information provided in the Equipment, Instrument, and Hierarchy templates. As shown in FIG. 2, the data can be received as a set of templates 210 by a gateway 220. In some embodiments, the set of templates 210 can be received by a web client prior to being provided to the gateway 220.

The server computing device 215 can include components and services configured to receive data characterizing data, a device, and/or a system configured within an oil and gas production environment. The server computing device 215 and the architecture of components depicted in FIG. 2, can provide service features of an AMS including, but not limited to, classifying assets and tags, transforming sets of templates, and performing asset model ingestion processing by ingesting bulk upload of assets, and/or creating assets one at a time. The server computing device 215 can further provide service features including removing an asset and it's children and querying an asset for more information.

During asset and tag classification, the set of templates 210 received by the gateway 220 can be provided to an asset logic component 225. The asset logic component 2225 classifies each item within the set of templates 210. The classifications are derived from the items in the Hierarchy, Equipment, and Instrument templates. The classified items can be stored in an asset database 230. By storing the classified items in the database 230, the AMS can obtain all assets by their classification.

During asset transformation, the gateway 220 can direct the set of templates to a parse logic component 235. The parse logic component 235 enables transformation of the set of templates 210 into representation JSON files, which can be stored in a database 240. In some embodiments, the database 240 can include a relational database. In some embodiments, the parse logic component can provide the representation JSON file to a Binary Large Object (BLOB) store 245. The BLOBstore 245 can include a collection of binary data, e.g., the representation JSON files, which can be stored as a single entity, such as a multi-dimensional array. When a set of valid asset templates 210 has been provided, asset model transformation can be initiated programmatically or via user request. Once a request is received the parse logic component 235 can retrieve all templates 210 and can transform the representation JSON into an asset model based on the required fields included in the set of templates 210. A job to transform the representation JSON file can be scheduled in the transformation message queue 250. The transformation job can provide the representation JSON file to a transformation logic component 255 to determine a corresponding asset model. In some embodiments, the asset model can be coded as shown in the code sample (1) below.

```
       (1) {"id":"PG", "uuid":"FORCE∼SITH∼PG", "name":"Acme",
           "tree":"Force>Sith>Acme", "parent":"SITH", "classification":"platform",
           "metadata": {"description":"This is the Acme platform",
           "timezone":" America/Chicago"} }
```

During bulk ingestion and processing of assets, multiple assets can be processed at a time. Once the set of templates 210 are populated, they can be provided as in a compressed file format, such as a .zip file format. The set of templates can be extracted from the compressed file format by the parse logic component 235 and stored in the BLOBstore 245. When parsing is complete, the set of templates 210 can be validated based on validation rules. Errors can be stored and reviewed by a user. After any errors have been reviewed, the user can cancel or proceed with the ingestion. Once ingestion is initiated, the transformation process can begin and the asset model can be created.

The parse logic component 250 can queue the set of templates for transformation in the transformation message queue 250 in preparation to determine the representation JSON file using the transformation logic component 255. In some embodiments, the representation JSON file can be a flat file including all information stored in the set of templates 210. As the transformation progresses, status data can be provided to a status message queue 260.

In some embodiments, a user can create an asset model for a single asset via a GUI. For example, a user can build an entire asset hierarchy for the asset. The single asset can be implemented directly as an asset model without requiring parsing and transformation of the set of templates 210. The asset model for the single asset can be stored in the asset database 230 and/or a cache 270. During asset removal, an asset and its associated child items can be removed from an asset model. Removing an asset and it's children can ensure that no orphan data remains in the asset model and maintains the asset model in a functional, clean state. Changes to an asset can be common and expected. For example, equipment can be replaced, or a transmitter can be added to a piece of equipment to convey measurement data. The removal and/or re-parenting of equipment may not update existing records, however the update can be reflected in all new records. Asset updates can be scheduled and managed via an asset update message queue 265.

During asset query, a user can query an asset, view asset data, and visualize, via a UI, how the asset is connected with the asset model and/or the data, device, or system represented by the asset model. Queries can be supported via an REST API implantation to allow microservice applications to communicate with it and to retrieve information about a particular asset.

The improved system as described herein addresses the technical problem of ingesting large amount of asset data and efficiently generating an asset model that is not restricted by complex asset hierarchies. The exemplary technical effects of the methods, systems, and computer-readable mediums described herein can include reduced errors in asset models created for large numbers of assets with complex inter-related components. Utilizing template data to characterize required data associated with an asset can ensure repeatable and efficient asset model creation which can further benefit the AMS in which the asset model may be implemented. In addition, an improved user interface for creating an asset model and managing asset model changes can be provided from the subject matter described herein.

One or more aspects or features of the subject matter described herein can be realized in digital electronic circuitry, integrated circuitry, specially designed application specific integrated circuits (ASICs), field programmable gate arrays (FPGAs) computer hardware, firmware, software, and/or combinations thereof. These various aspects or features can include implementation in one or more computer programs that are executable and/or interpretable on a programmable system including at least one programmable processor, which can be special or general purpose, coupled to receive data and instructions from, and to transmit data and instructions to, a storage system, at least one input device, and at least one output device. The programmable system or computing system may include clients and servers. A client and server are generally remote from each other and typically interact through a communication network. The relationship of client and server arises by virtue of computer programs running on the respective computers and having a client-server relationship to each other.

These computer programs, which can also be referred to as programs, software, software applications, applications, components, or code, include machine instructions for a programmable processor, and can be implemented in a high-level procedural language, an object-oriented programming language, a functional programming language, a logical programming language, and/or in assembly/machine language. As used herein, the term "machine-readable medium" refers to any computer program product, apparatus and/or device, such as for example magnetic discs, optical disks, memory, and Programmable Logic Devices (PLDs), used to provide machine instructions and/or data to a programmable processor, including a machine-readable medium that receives machine instructions as a machine-readable signal. The term "machine-readable signal" refers to any signal used to provide machine instructions and/or data to a programmable processor. The machine-readable medium can store such machine instructions non-transitorily, such as for example as would a non-transient solid-state memory or a magnetic hard drive or any equivalent storage medium. The machine-readable medium can alternatively or additionally store such machine instructions in a transient manner, such as for example as would a processor cache or other random access memory associated with one or more physical processor cores.

To provide for interaction with a user, one or more aspects or features of the subject matter described herein can be implemented on a computer having a display device, such as for example a cathode ray tube (CRT) or a liquid crystal display (LCD) or a light emitting diode (LED) monitor for displaying information to the user and a keyboard and a pointing device, such as for example a mouse or a trackball, by which the user may provide input to the computer. Other kinds of devices can be used to provide for interaction with a user as well. For example, feedback provided to the user can be any form of sensory feedback, such as for example visual feedback, auditory feedback, or tactile feedback; and input from the user may be received in any form, including acoustic, speech, or tactile input. Other possible input devices include touch screens or other touch-sensitive devices such as single or multi-point resistive or capacitive trackpads, voice recognition hardware and software, optical scanners, optical pointers, digital image capture devices and associated interpretation software, and the like.

In the descriptions above and in the claims, phrases such as "at least one of' or "one or more of' may occur followed by a conjunctive list of elements or features. The term "and/or" may also occur in a list of two or more elements or features. Unless otherwise implicitly or explicitly contradicted by the context in which it is used, such a phrase is intended to mean any of the listed elements or features individually or any of the recited elements or features in combination with any of the other recited elements or features. For example, the phrases "at least one of A and B;" "one or more of A and B;" and "A and/or B" are each intended to mean "A alone, B alone, or A and B together." A similar interpretation is also intended for lists including three or more items. For example, the phrases "at least one of A, B, and C;" "one or more of A, B, and C;" and "A, B, and/or C" are each intended to mean "A alone, B alone, C alone, A and B together, A and C together, B and C together, or A and B and C together." In addition, use of the term "based on," above and in the claims is intended to mean, "based at least in part on," such that an unrecited feature or element is also permissible.

The subject matter described herein can be embodied in systems, apparatus, methods, and/or articles depending on the desired configuration. The implementations set forth in the foregoing description do not represent all implementations consistent with the subject matter described herein. Instead, they are merely some examples consistent with aspects related to the described subject matter. Although a few variations have been described in detail above, other modifications or additions are possible. In particular, further features and/or variations can be provided in addition to those set forth herein. For example, the implementations described above can be directed to various combinations and subcombinations of the disclosed features and/or combinations and subcombinations of several further features disclosed above. In addition, the logic flows depicted in the accompanying figures and/or described herein do not necessarily require the particular order shown, or sequential order, to achieve desirable results. Other implementations may be within the scope of the following claims.

## Claims

1. A method comprising:
receiving data characterizing a configuration of an asset, the asset including one of data, a device, and/or a system configured within an oil and gas production environment, the data including attribute-value pairs identifying attributes of the configuration of the asset and values of the attributes, wherein the attribute-value pairs correspond to a hierarchical structure of the asset and sub-components of the asset;
determining a representation of the asset based on the attribute-value pairs included in the received data, the representation provided in a language-independent format suitable for use with data interchange application programming interfaces;
determining an asset model of the asset based on the representation, the asset model including a digital representation characterizing the hierarchical structure of the asset and sub-components of the asset, the asset model including computer-readable, executable content associated with the attribute-value pairs; and
providing the asset model.

2. The method of claim 1, wherein the data characterizing the configuration of the asset is received as a set of templates including a hierarchy template, an equipment template, an instrument template, and a connections template, each template in the set of templates including one or more fields identifying the attribute-value pairs.

3. The method of claim 2, wherein the hierarchy template includes fields for attribute-value pairs characterizing the asset as a customer, a region, and/or a system.

4. The method of claim 2, wherein the equipment template includes fields for attribute-value pairs characterizing an equipment type of the asset.

5. The method of claim 2, wherein the instrument template includes fields for attribute-value pairs characterizing the asset as a transmitter and/or a tag.

6. The method of claim 2, wherein the connections template includes fields for attribute-value pairs characterizing a mapping between the fields of the hierarchy template, the fields of the equipment template, and the fields of the instrument template.

7. The method of claim 1, further comprising
validating the received data using a plurality of rules characterizing valid configurations of the attribute-value pairs associated with the asset;
validating the representation using a plurality of rules characterizing valid configurations of the representation; and
wherein, providing the asset model includes providing the asset model for execution in an asset management application.

8. The method of claim 7, further comprising providing an error message indicative of an invalid configuration of the asset based on at least one rule characterizing valid configurations of the attribute-value pairs failing to validate the received data.

9. The method of claim 7, wherein the data characterizing the configuration of the asset is provided by a user during one of addition, updating, and removal of the asset within the asset model via the asset management application, wherein determining the representation and determining the asset model is performed via one or more messaging queues within a microservices architecture, and wherein the asset model application is configured to manage asset capabilities by at least providing predictions of asset failures, asset configuration warnings, and recommendations of asset operating parameters based on executing the asset model.

10. The method of claim 7, wherein the asset management application is configured to receive sensor data associated with operating parameters of the asset as inputs to the asset model and to execute the asset model, the execution causing the asset management application to provide alerts based on the sensor data exceeding pre-determined threshold values of the operating parameters.

11. The method of claim 1, wherein the received data characterizing the configuration of the asset is received in a compressed file format.

12. The method of claim 1, wherein the representation is a JavaScript object notation file and includes the attribute-value pairs as serializable values.

13. A system comprising:
at least one data processor; and
memory storing instructions configured to cause the at least one data processor to perform operations comprising:
receiving data characterizing a configuration of an asset, the asset including one of data, a device, and/or a system configured within an oil and gas production environment, the data including attribute-value pairs identifying attributes of the configuration of the asset and values of the attributes, wherein the attribute-value pairs correspond to a hierarchical structure of the asset and sub-components of the asset;
determining a representation of the asset based on the attribute-value pairs included in the received data, the representation provided in a language-independent format suitable for use with data interchange application programming interfaces;
determining an asset model of the asset based on the representation, the asset model including a digital representation characterizing the hierarchical structure of the asset and sub-components of the asset, the asset model including computer-readable, executable content associated with the attribute-value pairs; and
providing the asset model.

14. The system of claim 13, wherein the data characterizing the configuration of the asset is received as a set of templates including a hierarchy template, an equipment template, an instrument template, and a connections template, each template in the set of templates including one or more fields identifying the attribute-value pairs.

15. The system of claim 14, wherein the hierarchy template includes fields for attribute-value pairs characterizing the asset as a customer, a region, and/or a system.

16. The system of claim 14, wherein the wherein the equipment template includes fields for attribute-value pairs characterizing an equipment type of the asset.

17. The system of claim 14, wherein the instrument template includes fields for attribute-value pairs characterizing the asset as a transmitter and/or a tag.

18. The system of claim 14, wherein the connections template includes fields for attribute-value pairs characterizing a mapping between the fields of the hierarchy template, the fields of the equipment template, and the fields of the instrument template.

19. The system of claim 13, wherein the instructions stored in memory further cause the at least one data processor to perform operations including
validating the received data using a plurality of rules characterizing valid configurations of the attribute-value pairs associated with the asset;
validating the representation using a plurality of rules characterizing valid configurations of the representation; and
wherein, providing the asset model includes providing the asset model for execution in an asset management application.

20. A non-transitory computer program product storing instructions which, when executed by at least one data processor forming part of at least one computing system, cause the at least one data processor to implement operations comprising:
receiving data characterizing a configuration of an asset, the asset including one of data, a device, and/or a system configured within with an oil and gas production environment, the data including attribute-value pairs identifying attributes of the configuration of the asset and values of the attributes, wherein the attribute-value pairs correspond to a hierarchical structure of the asset and sub-components of the asset;
determining a representation of the asset based on the attribute-value pairs included in the received data, the representation provided in a language-independent format suitable for use with data interchange application programming interfaces;
determining an asset model of the asset based on the representation, the asset model including a digital representation characterizing the hierarchical structure of the asset and sub-components of the asset, the asset model including computer-readable, executable content associated with the attribute-value pairs; and
providing the asset model.
